# EUROPÄISCHE PATENTSCHRIFT

(11) **EP 1 336 179 B1**
(45) Veröffentlichungstag und Bekanntmachung des Hinweises auf die Patenterteilung: **13.04.2005**
(21) Anmeldenummer: 01982142.0
(22) Anmeldetag: 26.09.2001
(51) Int. Cl.: G11C 11/16

(54) **INTEGRIERTE MAGNETORESISTIVE HALBLEITERSPEICHERANORDNUNG**
INTEGRATED MAGNETORESISTIVE SEMICONDUCTOR MEMORY SYSTEM
ENSEMBLE MEMOIRE A SEMICONDUCTEURS MAGNETORESISTIVE INTEGREE

(30) Priorität: 16.11.2000 DE 10056830
(43) Veröffentlichungstag der Anmeldung: 20.08.2003
(73) Patentinhaber: Infineon Technologies AG, 81669 München (DE)
(72) Erfinder: BOEHM, Thomas, 85604 Zorneding (DE); ROEHR, Thomas, 85609 Aschheim (DE); HOENIGSCHMID, Heinz, Essex Junction, VT 05452 (US)
(74) Vertreter: Kottmann, Heinz Dieter, Dipl.-Ing.
(86) Internationale Anmeldenummer: PCT/DE2001/003690
(87) Internationale Veröffentlichungsnummer: WO 2002/041321

(56) Entgegenhaltungen:
- EP-A- 0 959 475
- US-A- 3 878 542
- PATENT ABSTRACTS OF JAPAN vol. 006, no. 241 (P-158), 30. November 1982 (1982-11-30) & JP 57 138092 A (SANYO DENKI KK), 26. August 1982 (1982-08-26)

## Beschreibung

Die Erfindung betrifft eine integrierte magnetoresistive Halbleiterspeicheranordnung, bei der n Speicherzellen, die jeweils zwei durch eine dünne dielektrische Barriere getrennte magnetoresistive Lagen und zugehörige einander orthogonal kreuzende Wortleitungen und Bitleitungen aufweisen, in n vertikalen Lagen übereinander gestapelt sind, und eine Decodierschaltung zur Auswahl einer der n Speicherlagen vorgesehen ist.

Bei magnetoresistiven Speichern (MRAMs) liegt der Speichereffekt im magnetisch veränderbaren elektrischen Widerstand der Speicherzelle.

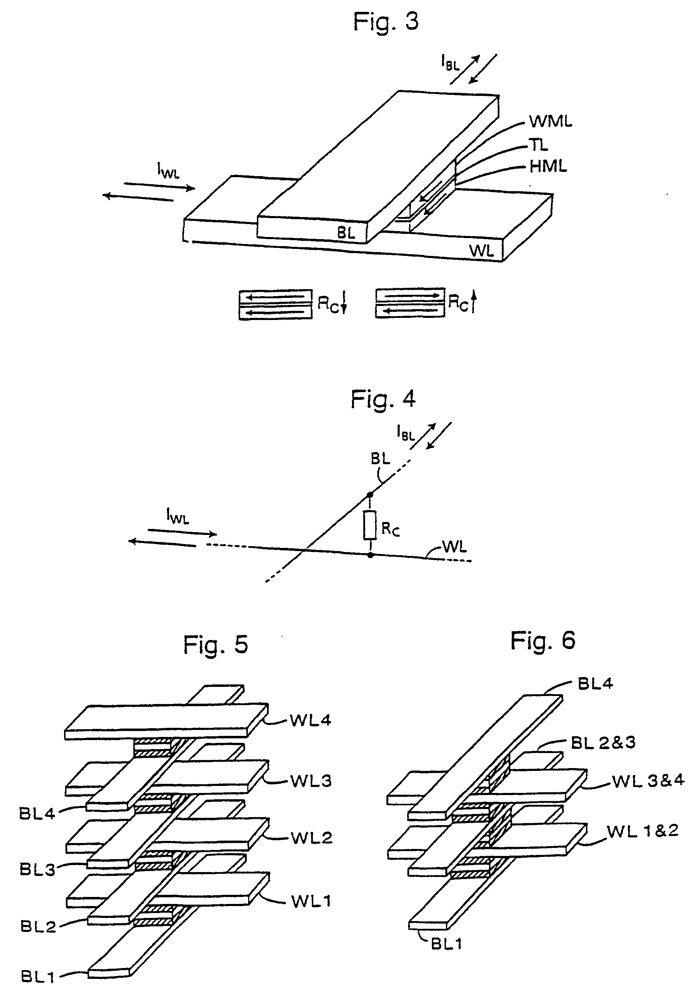

Die beiliegende Fig. 3 zeigt in einer perspektivischen Ansicht schematisch eine bekannte magnetoresistive Speicherzelle, die eine Kreuzung zweier Leiter, einer Bitleitung BL und einer Wortleitung WL aufweist, die üblicherweise orthogonal zueinander angeordnet sind. An der Kreuzungsstelle zwischen diesen Leitern WL und BL befindet sich ein bestimmtes Mehrschichtsystem, das aus einem Stapel einer Schicht WML eines weichmagnetischen Materials und einer Schicht HML eines hartmagnetischen Materials besteht, zwischen denen sich eine Schicht TL eines Tunneloxids befindet. Der Wert Rc des in der Speicherzelle enthaltenen Widerstandes zwischen den Leitern WL und BL hängt davon ab, ob die Magnetisierungsrichtungen in den weichmagnetischen und hartmagnetischen Schichten WML und HML parallel (niedriger Wert Rc) oder antiparallel (hoher Wert Rc) liegen. Dies ist im unteren Teil der Fig. 3 angedeutet.

Das Schreiben der Zelle geschieht durch Schalten der weichmagnetischen Schicht WML durch ein elektromagnetisches Feld. Zum Schalten ist eine Überlagerung zweier magnetischer Felder nötig. Damit die weichmagnetische Schicht WML in zwei entgegengesetzte Richtungen polarisiert werden kann, ist es erforderlich, dass mindestens einer der Programmierströme I_{BL} oder I_{WL} in beiden Richtungen durch die entsprechenden Leitungen fließen kann. Dies ist in Fig. 3 und auch in der beiliegenden Fig. 4 dargestellt, die eine Ersatzschaltung der in Fig. 3 in geometrischer Anordnung dargestellten Speicherzelle zeigt.

Ein großer Vorteil von MRAMs gegenüber anderen integrierten Halbleiterspeichern besteht darin, dass mehrere Speicherzellen übereinandergestapelt werden können. Dadurch wird in entscheidendem Maß Chipfläche eingespart. Die einzelnen übereinandergestapelten Ebenen (Lagen) werden entweder gemäß der beiliegenden Fig. 5 durch Oxidebenen voneinander getrennt oder gemäß Fig. 6 in Form eines "Shared Layer"-Stapels ohne Zwischenoxid ausgeführt, wobei die Bitleitungen BL2 und 3 und die Wortleitungen WL1 und WL2 einerseits und WL3 und WL4 andererseits jeweils gemeinsam sind.

Der geschilderte Vorteil von MRAMs, Speicherzellen in mehreren vertikalen Ebenen oder Lagen übereinanderzustapeln erfordert neue schaltungstechnische Lösungen zur Decodierung der vertikal angeordneten Speicherebenen zusätzlich zur konventionellen Decodierung der horizontalen Leitungen.

Es ist somit Aufgabe der Erfindung, eine integrierte magnetoresistive Halbleiterspeicheranordnung mit einer kostengünstigen und praktisch realisierbaren Decodierschaltung anzugeben, die eine Auswahl aus einer der n vertikal übereinander angeordneten Speicherlagen vornehmen kann.

Die Aufgabe wird anspruchsgemäß gelöst.

Gemäß einem ersten wesentlichen Aspekt der Erfindung weist die Decodierschaltung zur Decodierung von einer aus n Speicherlagen an beiden Enden einer Wortleitung oder Bitleitung jeweils eine Anordnung aus n Lagenauswahltransistoren und einen Leitungsauswahltransistor auf zur Auswahl der anzusprechenden horizontalen Wort- bzw. Bitleitung, die mit einer Spannung zu beaufschlagen ist.

Gemäß einem anderen Aspekt der Erfindung, der ein Hybriddecodierkonzept bildet, weist die Decodierschaltung - im Falle die n vertikalen Speicherlagen in die Z-Richtung, die Bitleitungen in die Y-Richtung und die sie orthogonal kreuzenden Wortleitungen in die X-Richtung eines gedachten rechtwinkligen Koordinatensystems weisen bzw. laufen - an beiden Enden einer Wortleitung einen X-Auswahltransistor zur Auswahl z. B. einer Wortleitung, einen Z-Auswahltransistor zur Auswahl der entsprechenden Speicherlage in Z-Richtung und ferner Y-Auswahltransistoren zur Decodierung in Y-Richtung mittels Column-Select-Leitungen (zum Beispiel Master-Wordline und segmentierte WL-Stücke).

Bei beiden integrierten magnetoresistiven Halbleiterspeicheranordnungen sind die die Decodierschaltung bildenden Transistoren an beiden Enden einer Wortleitung bzw. Bitleitung zu implementieren. Dabei sind die Source- oder Drainanschlüsse der Lagenauswahltransistoren bzw. der Y-Auswahltransistoren miteinander verbunden, und die Transistoren teilen sich ein gemeinsames Diffusionsgebiet, während die anderen Elektrodenanschlüsse voneinander unabhängige Wort- bzw. Bitleitungen beschalten. Jeder Transistor der Decodierschaltung ist so ausgelegt, dass er den für eine Speicherzelle erforderlichen hohen Schreibstrom von typischerweise 2 mA treiben kann.

Ausführungsbeispiele der erfindungsgemäßen integrierten magnetoresistiven Halbleiterspeicheranordnung sind in der nachstehenden, Bezug auf die beiliegende Zeichnung nehmenden, Beschreibung näher erläutert.

Die Zeichnungsfiguren zeigen im einzelnen:
- Fig. 1: ein Schaltbild eines ersten Ausführungsbeispiels einer Decodierschaltung für eine erfindungsgemäße integrierte magnetoresistive Halbleiterspeicheranordnung,
- Fig. 2: ein Schaltschema eines zweiten Ausführungsbeispiels einer Decodierschaltung für eine erfindungsgemäße integrierte magnetoresistive Halbleiterspeicheranordnung,
- Fig. 3: die bereits erörterte schematische Darstellung einer magnetoresistiven Halbleiterspeicherzelle,
- Fig. 4: die bereits erläuterte Ersatzschaltung für die in Fig. 3 dargestellte magnetoresistive Speicherzelle,
- Fig. 5: eine erste Art der Stapelung von magnetoresistiven Halbleiterspeicherzellen in beispielhaft vier vertikalen Lagen mit Zwischenoxid, und
- Fig. 6: ein zweites Beispiel einer vertikalen Stapelung von vier magnetoresistiven Halbleiterspeicherzellen in Lagen ohne Zwischenoxid.

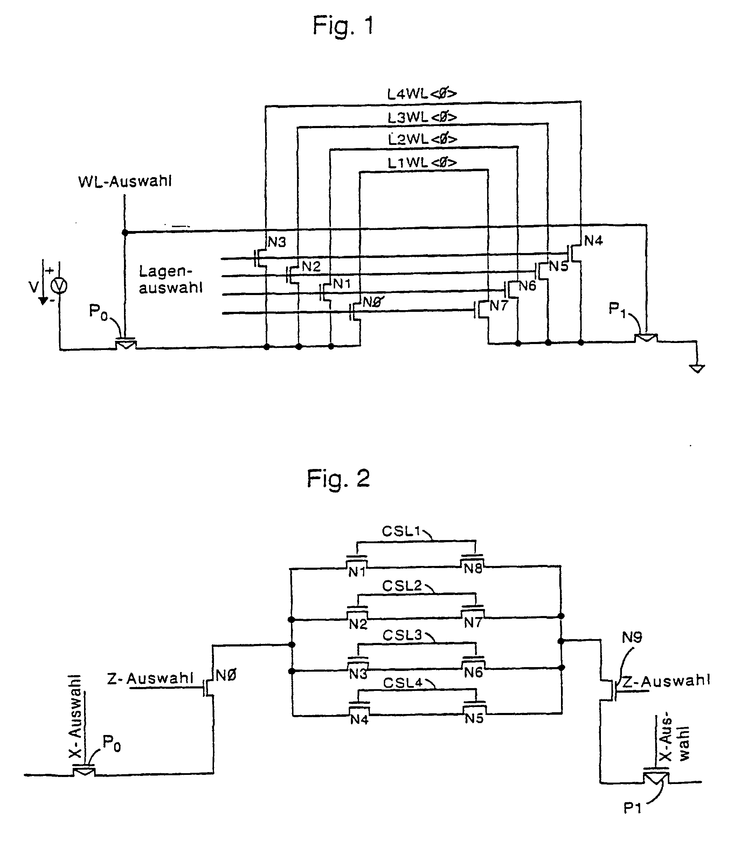

Fig. 1 ist ein Schaltbild einer für z.B. vier vertikal übereinandergestapelte Lagen magnetoresistiver Halbleiterspeicherzellen eingerichteten Decodierschaltung, die die Auswahl von einer aus n Lagen magnetoresistiver Speicherzellen durch die an beiden Enden einer Wortleitung oder Bitleitung angeordneten Lagenauswahltransistoren N0 - N3 und N4 - N7 gestattet. Leitungsauswahltransistoren P0 und P1 wählen die anzusprechende horizontale Leitung, die im Beispiel eine Wortleitung WL<0> ist, die aber auch eine Bitleitung BL sein kann, die mit der Spannung V zu beschalten ist. Die nachfolgende Anordnung aus 4 Lagenauswahltransistoren N0 - N3 und N7, N6, N5 und N4 auf beiden Seiten wählt eine der vertikal angeordneten Speicherlagen L1 - L4 aus. Die Sourceanschlüsse bzw. Drainanschlüsse an einem Ende der Lagenauswahltransistoren N0 - N3 einerseits und N4 - N7 andererseits sind miteinander verbunden.

Im Layout teilen sich die Transistoren N0 - N3 einerseits und N4 - N7 andererseits ein Diffusionsgebiet und beschalten jeweils andere voneinander unabhängige Wort- bzw. Bitleitungen. Mit einer versetzten Anordnung der Lagenauswahltransistoren N0 - N3 einerseits und N4 - N7 andererseits ist ein platzsparendes Layout in einem für MRAM typischen engen WL/BL Pitch möglich. Die verwendeten Transistoren müssen den für das Schreiben einer MRAM-Zelle typischen hohen Schreibstrom von 2 mA treiben können. Es soll bemerkt werden, dass im dargestellten Ausführungsbeispiel die Anzahl von vier übereinandergestapelten Speicherlagen lediglich beispielhaft ist. Dementsprechend enthält, wenn eine andere Anzahl übereinandergestapelter Speicherlagen vorliegt, die Decodierschaltung, eine entsprechende Anzahl von Transistoren zur Lagenauswahl.

Fig. 2 zeigt eine Schaltungsanordnung eines zweiten Ausführungsbeispiels einer Decodierschaltung für eine erfindungsgemäße integrierte magnetoresistive Halbleiterspeicheranordnung.

Hier ist angenommen, dass die n vertikal übereinandergestapelten Lagen magnetoresistiver Speicherzellen in Z-Richtung, die Bitleitungen in Y-Richtung und die sie kreuzenden Wortleitungen in X-Richtung eines rechtwinkligen Koordinatensystems angeordnet sind. Die in Fig. 2 dargestellte Decodierschaltung weist am linken und rechten Ende jeweils einen X-Auswahltransistor P0, P1 zur Auswahl einer Leitung in X-Richtung, einen Z-Auswahltransistor N0 und N9 zur Auswahl der entsprechenden Speicherlage in Z-Richtung und eine Anordnung von Y-Auswahltransistoren N1 - N4 einerseits und N5 - N8 andererseits zur Decodierung in Y-Richtung durch die Column-Select-Leitungen CSL1 - CSL4 (z.B. Master-Wordline und segmentierte WL-Stücke) auf. Für die Anordnung der Transistoren im Layout und ihre Auslegung, damit sie den benötigten hohen Schreibstrom für die magnetoresistive Speicherzelle treiben können, gilt sinngemäß dasselbe, wie es oben für das in Fig. 1 dargestellte Ausführungsbeispiel erläutert wurde.

Statt orthogonal sich kreuzende Wort- und Bitleitungen zu verwenden, können layout-technisch auch andere Anordnungsvarianten realisiert werden, um beispielsweise die Vorzugs-Drehrichtung der Polarisation in der weichmagnetischen Schicht WML gezielt zu beeinflussen.

### Bezugszeichenliste

- BL: Bitleitung
- WL: Wortleitung
- I_{BL}: Strom durch die Bitleitung BL
- I_{WL}: Strom durch die Wortleitung WL
- R_{c}: Widerstand der magnetoresistiven Speicherzelle
- WML: weichmagnetische Schicht
- HML: hartmagnetische Schicht
- TL: Tunneloxidschicht
- N0 - N7, P0, P1: Auswahltransistoren
- N0 - N9, P0, P1: Auswahltransistoren
- L1 - L4: Lage der Speicherzelle

## Patentansprüche

1. Integrierte magnetoresistive Halbleiterspeicheranordnung, bei der n Speicherzellen, die jeweils zwei durch eine dünne dielektrische Barriere (TL) getrennte magnetische Lagen (WML, HML) und zugehörige einander kreuzende Wortleitungen (WL) und Bitleitungen (BL) aufweisen, in n Lagen (L1, L2, L3) vertikal übereinandergestapelt sind, und eine Decodierschaltung zur Auswahl einer der n Speicherlagen (L1 - L4) vorgesehen ist,
**dadurch gekennzeichnet,**
**dass** die Decodierschaltung an beiden Enden einer Wortleitung (WL) bzw. Bitleitung (BL) jeweils eine Anordnung aus n Lagenauswahltransistoren (N0 - N3, N4 - N7) zur Auswahl einer der n Speicherlagen (L1 - L4) und einen Leitungsauswahltransistor (P0, P1) zur Auswahl der anzusprechenden horizontalen Wort- bzw. Bitleitung (WL bzw. BL) aufweist, die mit einer Spannung (V) zu beaufschlagen ist.

2. Integrierte magnetoresistive Halbleiterspeicheranordnung, bei der n Speicherzellen, die jeweils zwei durch eine dünne dielektrische Barriere (TL) getrennte magnetische Lagen (WML, HML) und zugehörige einander kreuzende Wort- und Bitleitungen (WL und BL) aufweisen, in n Lagen (L1, L2, L3, L4) vertikal übereinandergestapelt sind und eine Decodierschaltung zur Auswahl einer der n Speicherlagen (L1 - L4) vorgesehen ist, wobei die n vertikalen Lagen in Z-Richtung, die Bitleitungen bzw. Wortleitungen in Y-Richtung und die sie kreuzenden Wortleitungen bzw. Bitleitungen in X-Richtung eines gedachten Koordinatensystems angeordnet sind,
**dadurch gekennzeichnet,**
**dass** die Decodierschaltung an beiden Enden einer Wortleitung (WL) oder Bitleitung (BL) einen X-Auswahltransistor (P0, P1) zur Auswahl einer Leitung in X-Richtung, einen Z-Auswahltransistor (N0, N9) zur Auswahl der entsprechenden Speicherlage in Z-Richtung und Y-Auswahltransistoren (N1-N4 und N5-N8) zur Decodierung in Y-Richtung mittels Column-Select-Leitungen (CSL1 - CSL4) aufweist.

3. Integrierte magnetoresistive Halbleiterspeicheranordnung nach Anspruch 1 oder 2,
**dadurch gekennzeichnet,**
**dass** die Y-Auswahltransistoren bzw. die Lagenauswahltransistoren an einem ihrer Elektrodenanschlüsse (Source oder Drain) untereinander verbunden sind, sich ein gemeinsames Diffusionsgebiet teilen und am entgegengesetzten Elektrodenanschluss voneinander unabhängige Wort- bzw. Bitleitungen beschalten.

4. Integrierte magnetoresistive Halbleiterspeicheranordnung nach einem der Ansprüche 1 bis 3,
**dadurch gekennzeichnet,**
**dass** jeder Transistor der Decodierschaltung so ausgelegt ist, dass er den für jede Speicherzelle der Speicheranordnung benötigten relativ hohen Schreibstrom treiben kann.

## Claims

1. Integrated magnetoresistive semiconductor memory arrangement, in which n memory cells which each have two magnetic layers (WML, HML), separated by a thin dielectric barrier (TL), and associated word lines (WL) and bit lines (BL) that cross one another are stacked vertically one above the other in n layers (L1, L2, L3), and provision is made of a decoding circuit for selecting one of the n memory layers (L1 - L4),
**characterized**
**in that** the decoding circuit, at both ends of a word line (WL) or bit line (BL), in each case has an arrangement comprising n layer selection transistors (N0 - N3, N4 - N7) for selecting one of the n memory layers (L1 - L4) and a line selection transistor (P0, P1) for selecting the horizontal word or bit line (WL or BL, respectively) which is to be addressed and to which a voltage (V) is to be applied.

2. Integrated magnetoresistive semiconductor memory arrangement, in which n memory cells which' each have two magnetic layers (WML, HML), separated by a thin dielectric barrier (TL), and associated word and bit lines (WL and BL) that cross one another are stacked vertically one above the other in n layers (L1, L2, L3, L4), and provision is made of a decoding circuit for selecting one of the n memory layers (L1 - L4), the n vertical layers being arranged in the Z direction, the bit lines or word lines being arranged in the Y direction and the word lines or bit lines, respectively, that cross them being arranged in the X direction of an imaginary system of coordinates,
**characterized**
**in that** the decoding circuit, at both ends of a word line (WL) or bit line (BL), has an X selection transistor (P0, P1) for selecting a line in the X direction, a Z selection transistor (N0, N9) for selecting the corresponding memory layer in the Z direction and Y selection transistors (N1 - N4 and N5 - N8) for decoding in the Y direction by means of column select lines (CSL1 - CSL4).

3. Integrated magnetoresistive semiconductor memory arrangement according to Claim 1 or 2,
**characterized**
**in that** the Y selection transistors or the layer selection transistors are interconnected at one of their electrode terminals (source or drain), share a common diffusion region and connect up word or bit lines that are independent of one another at the opposite electrode terminal.

4. Integrated magnetoresistive semiconductor memory arrangement according to one of Claims 1 to 3,
**characterized**
**in that** each transistor of the decoding circuit is designed in such a way that it can drive the relatively high write current required for each memory cell of the memory arrangement.

## Revendications

1. Dispositif intégré de mémoire à semi-conducteurs magnétorésistive, dans lequel n cellules de mémoire, qui ont respectivement deux couches (WML, HML) magnétiques séparées par une mince barrière (TL) diélectrique et des lignes (WL) de mots et des lignes (BL) de bits associées qui s'entrecroisent, sont superposées verticalement en n couches (L1, L2, L3), et il est prévu un circuit de décodage pour sélectionner l'une des n couches (L1 à L4) de mémoire,
**caractérisé**
**en ce que** le circuit de décodage comporte, aux deux extrémités d'une ligne (WL) de mots ou d'une ligne (BL) de bits, respectivement un agencement constitué de n transistors (N0 à N3, N4 à N7) de sélection de couche pour sélectionner l'une des n couches (L1 à L4) de mémoire et un transistor (P0, P1) de sélection de ligne pour sélectionner la ligne de mots ou de bits (WL ou BL) horizontale à déclencher à laquelle doit être appliquée une tension (V).

2. Dispositif intégré de mémoire à semi-conducteurs magnétorésistive, dans lequel n cellules de mémoire qui ont respectivement deux couches (WML, HML) magnétiques séparées par une mince barrière (TL) diélectrique et des lignes (WL et BL) de mots et de bits associées s'entrecroisant sont superposées verticalement en n couches (L1, L2, L3, L4) et il est prévu un circuit de décodage pour sélectionner l'une des n couches (L1 à L4) de mémoire, les n couches verticales étant disposées dans la direction Z, les lignes de bits ou les lignes de mots dans la direction Y et les lignes de mots ou les lignes de bits qui s'entrecroisent dans la direction X d'un système imaginaire de coordonnées,
**caractérisé**
**en ce que** le circuit de décodage a, aux deux extrémités d'une ligne (WL) de mots ou d'une ligne (BL) de bits, un transistor (P0, P1) de sélection X pour sélectionner une ligne dans la direction X, un transistor (N0, N9) de sélection Z pour sélectionner la couche de mémoire correspondante dans la direction Z et des transistors (N1 à N4 et N5 à N8) de sélection Y pour décoder dans la direction Y au moyen de lignes (CSL1 à CSL4) Column-Select.

3. Dispositif intégré de mémoire à semi-conducteurs magnétorésistive suivant la revendication 1 ou 2,
**caractérisé**
**en ce que** les transistors de sélection Y ou les transistors de sélection de couche sont reliés entre eux par leurs bornes d'électrodes (source ou drain), se partagent une zone commune de diffusion et sont connectés à la borne d'électrode opposée de lignes de mots ou de bits indépendantes les unes des autres.

4. Dispositif intégré de mémoire à semi-conducteurs magnétorésistive suivant l'une des revendications 1 à 3,
**caractérisé**
**en ce que** chaque transistor du circuit de décodage est conçu de manière à pouvoir appliquer le courant d'écriture relativement intense nécessité pour chaque cellule de mémoire du dispositif de mémoire.
